(19) Europäisches Patentamt
European Patent Office
Office européen des brevets

(11) **EP 4 456 118 A1**

(12) # EUROPEAN PATENT APPLICATION
published in accordance with Art. 153(4) EPC

(43) Date of publication:
**30.10.2024 Bulletin 2024/44**

(21) Application number: **22910619.0**

(22) Date of filing: **02.11.2022**

(51) International Patent Classification (IPC):
***H01L 21/302*** *(2006.01)*

(52) Cooperative Patent Classification (CPC):
**H01L 21/302**

(86) International application number:
**PCT/JP2022/040993**

(87) International publication number:
**WO 2023/119899 (29.06.2023 Gazette 2023/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.12.2021 JP 2021210305**

(71) Applicant: **AGC INC.**
**Chiyoda-ku,**
**Tokyo 1008405 (JP)**

(72) Inventors:
- **SANO, Kohei**
  **Tokyo 100-8405 (JP)**
- **ONO, Yoshitaka**
  **Tokyo 100-8405 (JP)**
- **HAYASHI, Yasuo**
  **Tokyo 100-8405 (JP)**
- **IMAMURA, Yutaka**
  **Tokyo 100-8405 (JP)**

(74) Representative: **Müller-Boré & Partner**
**Patentanwälte PartG mbB**
**Friedenheimer Brücke 21**
**80639 München (DE)**

(54) **METHOD FOR MANUFACTURING MEMBER HAVING RECESSED STRUCTURE, AND MEMBER HAVING RECESSED STRUCTURE**

(57) A method of manufacturing a member having a recessed structure, including: (1) setting a catalyst material on a portion of a first surface of a process target, wherein the first surface is made of an element that forms a fluoride having a boiling point of 550°C or less, and the catalyst material contains an organic compound containing a polar functional group; and (2) exposing the process target to a fluorine-containing gas at 80°C or higher, wherein through the (2), the recessed structure is formed in the first surface under the catalyst material.

FIG.7

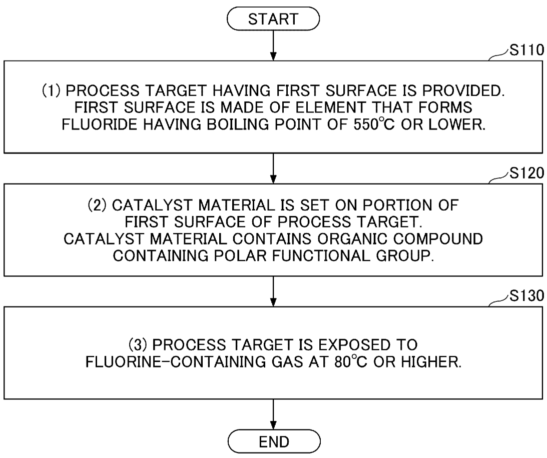


EP 4 456 118 A1

## Description

### Technical Field

The present invention relates to a method of manufacturing a member having a recessed structure, and a member having a recessed structure.

### Background Art

Microfabrication techniques capable of forming a fine recessed structure in the surface of a sample has needs in various fields. As microfabrication techniques, various methods have been proposed and put into practical use.

One of the microfabrication techniques is dry etching, in which the surface of a sample is etched using a reactant selected from reactive gases, ions, and radicals.

For example, in the Reactive Ion Etching (RIE) method, represented by the Inductively Coupled Plasma-RIE (ICP-RIE) method, etching is performed by plasmatizing the etching gas and impinging it on the sample. It has been reported that such a RIE method enables extremely fine processing of the sample (for example, NPL 1).

### Citation List

### Non-Patent Literature

[NPL 1] Xiao Li, King Yuk Chan and Rodica Ramer, "Fabrication of Through via Holes in Ultra-Thin Fused Silica Wafers for Microwave and Millimeter-Wave Applications," Micromachines, 2018, 9, 138

### Summary of the Invention

### Technical Problem

However, in the RIE method, when a recessed structure is formed in the surface of the sample, the side walls tend to be tapered, and it is difficult to form a recessed structure close to an ideal shape (perpendicular structure).

The present invention has been made in view of this background, and it is an object of the present invention to provide a method capable of relatively easily manufacturing a member having a recessed structure close to a perpendicular structure. It is also an object of the present invention to provide a member having such a recessed structure.

### Solution to the Problem

The present invention provides a method of manufacturing a member having a recessed structure, the method including:

(1) setting a catalyst material on a portion of a first surface of a process target, wherein the first surface is made of an element that forms a fluoride having a boiling point of 550°C or less, and the catalyst material contains an organic compound containing a polar functional group; and
(2) exposing the process target to a fluorine-containing gas at 80°C or higher,

wherein through the (2), the recessed structure is formed in the first surface under the catalyst material.

The present invention also provides a member having a recessed structure in a first surface,

wherein the recessed structure is either or both of a bottomed structure and a through structure,
the first surface contains at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recessed structure is defined by a first opening formed in the first surface, surrounding side walls, and a bottom surface or a second opening, and
the side walls have at least one streak extending from the first opening to the bottom surface or the second opening.

The present invention also provides a member having a recessed structure in a first surface,

wherein the recessed structure is either or both of a bottomed structure and a through structure,
the first surface contains at least one element selected from the group consisting of B, C, Si, P, S, Ti, V, Cr, Ge, As,

Se, Nb, Mo, Tc, Ru, Rh, Sn, Sb, Te, I, Ta, W, Re, Os, Ir, Pt, and Au,
the recessed structure has a depth of 1 um or more, and has a first opening formed in the first surface and a bottom surface or a second opening, and
when a minimum dimension of the first opening is a, a minimum dimension of the bottom surface or the second opening of the recessed structure is b, the depth of the recessed structure is c, and an angle θ represented by an equation (1) below is referred to as a taper angle,
the taper angle θ is 0° ≤ θ ≤ 1°.
[Math. 1]

$$\text{Taper angle } \theta\ (°) = \cos^{-1}\left(\frac{c}{\sqrt{\left(\frac{a-b}{2}\right)^2 + c^2}}\right)$$

Equation (1)

Advantageous Effects of the Invention

The present invention can provide a method by which a member having a recessed structure close to a perpendicular structure can be manufactured relatively easily. The present invention can also provide a member having such a recessed structure.

Brief Description of the Drawings

[FIG. 1] FIG. 1 is a diagram exemplarily illustrating a reaction mechanism that may occur on the first surface of the process target when the organic compound contains no polar functional group.
[FIG. 2] FIG. 2 is a diagram exemplarily illustrating a reaction mechanism that may occur on the first surface of the process target when the organic compound contains a polar functional group.
[FIG. 3] FIG. 3 is a diagram exemplarily illustrating a reaction mechanism that may occur on the first surface of the process target when the organic compound contains any other polar functional group.
[FIG. 4] FIG. 4 is a graph illustrating the relationship between the processing temperature and the etching reaction rate during hydrogen fluoride (HF) gas etching of glass.
[FIG. 5] FIG. 5 is a cross-sectional view exemplarily illustrating a state of a process according to an embodiment of the present invention.
[FIG. 6] FIG. 6 is a cross-sectional view exemplarily illustrating a state of a process according to an embodiment of the present invention.
[FIG. 7] FIG. 7 is a diagram illustrating the outline of the flow of a method for manufacturing a member having a recessed structure according to an embodiment of the present invention.
[FIG. 8] FIG. 8 is a perspective view exemplarily illustrating a state in which a catalyst material is set on a process target in a method of manufacturing a member having a recessed structure according to an embodiment of the present invention.
[FIG. 9] FIG. 9 is a cross-sectional view exemplarily illustrating an example of a process target 110 after being etched in a method of manufacturing a member having a recessed structure according to an embodiment of the present invention.
[FIG. 10] FIG. 10 is a perspective view of a member according to an embodiment of the present invention.
[FIG. 11] FIG. 11 is an exemplary cross-sectional view of a member according to an embodiment of the present invention along a line A-A illustrated in FIG. 10.
[FIG. 12] FIG. 12 is a view exemplarily illustrating a surface configuration of a side wall of a recessed structure in a member according to an embodiment of the present invention.
[FIG. 13] FIG. 13 is a rough diagram illustrating a taper angle θ of a recessed structure.
[FIG. 14] FIG. 14 is an image illustrating an example of a cross-section of a recessed structure according to an embodiment of the present invention.
[FIG. 15] FIG. 15 is an image illustrating an example of a cross-section of a recessed structure according to another embodiment of the present invention.
[FIG. 16] FIG. 16 is an image illustrating an example of a cross-section of a recessed structure according to yet

another embodiment of the present invention.
[FIG. 17] FIG. 17 is an image illustrating an example of a cross-section of a recessed structure according to yet another embodiment of the present invention.
[FIG. 18] FIG. 18 is an image illustrating an example of a cross-section of a recessed structure formed by an existing method.
[FIG. 19] FIG. 19 is an image illustrating an example of a side wall configuration of a recessed structure according to an embodiment of the present invention.

Description of Embodiments

Hereinafter, an embodiment of the present invention will be described.
As described above, in the existing RIE method, when a recessed structure is formed in the surface of a sample, the side walls of the recessed structure tend to be formed in a "tapered shape", and it is difficult to form a recessed structure close to a perpendicular structure.
Here, the "tapered shape" means a shape resulting from side walls, which are to define a recessed structure, being inclined with respect to the axis of the recessed structure along which the recessed structure extends in the depth direction.
In order to cope with such existing problems, the present inventors have carried out intensive research and development, and found a microfabrication technique that can more easily form a recessed structure close to a perpendicular structure.
That is, one embodiment of the present invention provides a method of manufacturing a member having a recessed structure, the method including:

(1) setting a catalyst material on a part of a first surface of a process target, wherein the first surface is made of an element that forms a fluoride having a boiling point of 550°C or less, and the catalyst material contains an organic compound containing a polar functional group; and
(2) exposing the process target to a fluorine-containing gas at 80°C or higher,

wherein through the (2), a recessed structure is formed in the first surface under the catalyst material.
The method according to one embodiment of the present invention includes a process for exposing the process target, on the first surface of which the catalyst material is set, to the fluorine-containing gas at a processing temperature of 80°C or higher (hereinafter, this process is referred to as the "etching process of the present invention"). In the method according to one embodiment of the present invention, by performing the etching process of the present invention as described, it is possible to selectively etch a region, on which the catalyst material is set (hereinafter referred to as "coated region"), of the first surface of the process target.
Hereinafter, with reference to the drawings, the presently presumed reason why such an etching result can be achieved will be explained.
First, the role of the catalyst material and the effect of the processing temperature in the etching process of the present invention will be described.

(Role of the catalyst material)

In the etching process of the present invention, the catalyst material contains an organic compound containing a polar functional group. Such an organic compound containing a polar functional group is considered to have a role of lowering the activation energy for fluoride formation on the surface of the process target.
This role will be described below with reference to FIGS. 1 to 3. FIGS. 1 to 3 exemplarily illustrate how the reaction occurs on the surface of a process target on which the catalyst material is set.
In the following description, as an example, it is assumed that the process target is $SiO_2$ and the first surface is hydrogen-terminated.
First, FIG. 1 exemplarily illustrates an etching mechanism assumed on the first surface of the process target when the organic compound contains no polar functional group.
When a hydrogen fluoride (HF) gas is supplied from the environment to the region, on which the catalyst material is set, i.e., the "coated region", of the surface of $SiO_2$, which is the process target, the HF molecule (a) nucleophilically attacks the Si atom (b) as illustrated in (i).
However, in order for the Si atom (b) to react with the F atom on the surface of the process target, the OH group (c) on the surface needs to interact with the H atom of the HF molecule (a) and weaken the H-F bond as illustrated in (ii). That is, unless energy to break the H-F bond of the HF molecule (a) is provided, the Si-F bonding (d) involving elimination of $H_2O$ (g) as illustrated in (iii) does not occur.

However, in this reaction system, there is no substance that contributes to lowering the activation energy for the Si-F bonding (d). Therefore, no significant etching reaction proceeds in the coated region.

In this system, as in the common mask pattern processing, the etching rate tends to be higher on a region of the process target that is in direct contact with the HF gas, i.e., a region on which no catalyst material is set on the surface (hereinafter referred to as "uncoated region").

FIG. 2 exemplarily illustrates the reaction mechanism on the first surface of the process target when the organic compound contains a polar functional group. Here, a hydroxy group is assumed as the polar functional group.

Also in this case, when a HF gas is supplied from the environment to the catalyst material-coated region, the HF molecule (a) nucleophilically attacks the Si atom (b) as illustrated in (i).

However, in this case, the O atom of the -δ moiety (e) of the polar functional group additionally interacts with H of the HF molecule (a). Moreover, the H atom of the +5 moiety (f) of the polar functional group interacts with the OH group (c) of the surface.

Thus, as illustrated in (ii), the H-F bond of the HF molecule (a) is weakened. The Si (b)-OH (c) bond is also weakened. This reduces the activation energy required for the bonding reaction between the Si and F atoms.

As a result, as illustrated in (iii), the H atom of the HF molecule (a) is taken away by the O atom of the -δ moiety (e) of the polar functional group, and the H atom of the +5 moiety (f) reacts with the OH group on the surface, resulting in the elimination of $H_2O$ (g) .

Thus, the Si atom (b) is bonded with the fluorine atom. Ultimately, $SiF_4$ and $H_2O$ are formed through the following reaction formula (2).

$$SiO_2 + 4HF \rightarrow SiF_4\uparrow + 2H_2O\uparrow \qquad (2)$$

Both $SiF_4$ and $H_2O$ formed in the reaction are gaseous at the processing temperature, and quickly escape the system.

According to the above reaction mechanism, the process target is selectively etched at exactly under the catalyst material-coated region.

Occurrence of the above reaction is not limited to when the polar functional group contains a hydroxy group. For example, the same reaction can occur when the polar functional group contains at least one selected from an aldehyde group, a hydroxy group, a carboxy group, an amino group, a sulfo group, a thiol group, and an amide bond.

In FIG. 2, the reaction mechanism is described with reference to an example case where the polar functional group of the organic compound contains a H atom. However, the polar functional group of the organic compound is not necessarily limited to one that contains a H atom.

FIG. 3 exemplarily illustrates the reaction mechanism in a case where the organic compound contains another polar functional group. Here, a carbonyl group free of a H atom (>C=O) is assumed as the polar functional group.

In this example, when a HF gas is supplied from the environment to the catalyst material-coated region, the HF molecule (a) nucleophilically attacks the Si atom (b) as illustrated in (i). The O atom of the -δ moiety (e) of the polar functional group interacts with the H atom of the HF molecule (a).

This weakens the H-F bond of the HF molecule (a) as illustrated in (ii).

Next, as illustrated in (iii), the H atom separated from the HF molecule (a) by the O atom of the -δ moiety (e) of the polar functional group bonds with the OH group (c) to form $H_2O$ (g) .

Also in this case, the activation energy required for the bonding reaction between the Si and F atoms decreases. As a result, the reaction represented by the reaction formula (2) above occurs, and the process target is selectively etched at exactly under the coated region.

A similar reaction mechanism may occur also in a case where, for example, the polar functional group contains at least one selected from a carbonyl group, a nitro group, a cyano group, an ether bond, and an ester bond.

Thus, in the etching process of the present invention, the presence of an organic compound containing a polar functional group included in the catalyst material promotes a fluoride forming reaction in the coated region of process target, which can be selectively etched at exactly under the coated region.

(Effect of processing temperature)

Next, the effect of the processing temperature will be described.

In the etching process of the present invention, the processing temperature is 80°C or higher. This is because an appropriate etching selectivity does not occur between the coated region and the uncoated region on the first surface of process target at a temperature less than 80°C.

Hereinafter, the effect of the processing temperature will be described in more detail with reference to FIG. 4.

FIG. 4 indicates the relationship between the processing temperature and the etching reaction rate during hydrogen fluoride (HF) gas etching of glass obtained by the present inventors.

From FIG. 4, the glass etching rate gradually increases with respect to the temperature up to the processing temperature of 80°C. However, when the processing temperature is 80°C or higher, the etching rate sharply decreases. Hence, the etching rate has a peak at a temperature lower than 80°C.

This phenomenon is considered to correspond to the associated/non-associated state of the HF gas. That is, the HF gas is in the associated state below 80°C, but enters the non-associated (monomeric) state at 80°C or higher. When the HF gas is in the associated state, the binding force between the H-F bond in a single molecule is relatively weakened. Therefore, the F atom of HF molecule is facilitated to bond with the surface of the process target and to form a fluoride. It is considered that a high etching rate can be obtained below 80°C owing to this behavior.

In a case where the processing temperature is set to be less than 80°C in the etching process of the present invention, the catalyst material-uncoated region of the process target is etched due to the effect of such an associated state of the HF gas. Therefore, the etching selectivity in the coated region through the aforementioned reaction mechanism decreases.

On the other hand, when the processing temperature is set to be 80°C or higher, a high etching force due to the HF gas in the associated state can be suppressed in the catalyst material-uncoated region. In addition, based on the aforementioned reaction mechanism, the process target can be etched at exactly under the coated region. As a result, in the etching process of the present invention (at a processing temperature of 80°C or higher), a high etching selectivity can be obtained between the catalyst material-coated region and uncoated region. Moreover, owing to this, the coated region can be selectively etched in the etching process of the present invention.

(Recessed structure formed)

In the existing RIE method, the side walls of a recessed structure tend to be formed in a "tapered shape", and it is difficult to form a recessed structure close to a perpendicular structure.

In contrast, in the etching process of the present invention, it is relatively easy to form a recessed structure having no "tapered shape" and having side walls extending substantially in parallel with each other along the extension axis in the depth direction (hereinafter referred to as "perpendicular recessed structure").

Hereinafter, the reason for this will be described with reference to FIGS. 5 and 6.

FIGS. 5 and 6 exemplarily illustrate state of the etching process of the present invention.

FIG. 5 exemplarily illustrates a state in which the catalyst material 3 is set on the surface of the process target 1. In FIGS. 5 and 6, the process target 1 and the catalyst material 3 are illustrated as being separated from each other for the purpose of illustration, but in reality, they are in contact with each other.

As described above, it is assumed that the process target 1 is $SiO_2$, and the surface is H-terminated.

The catalyst material 3 is an organic compound containing a polar functional group, and an OH group is assumed as the polar functional group. By setting the catalyst material 3 on the surface of the process target 1, a coated region 8a and an uncoated region 8b are formed on the process target 1.

As described above, by the process target 1 heated to 80°C or higher being exposed to the HF gas, selective etching occurs exactly under the coated region 8a on which the catalyst material 3 is set. As a result, a recessed structure is formed exactly under the coated region 8a.

FIG. 6 illustrates a state in which etching of the process target 1 has progressed to a certain extent and a recessed structure 5 having a certain depth is formed.

As described above, the catalyst material 3 is set on the coated region 8a. Therefore, even though the etching reaction proceeds, the catalyst material 3 still exists on the bottom surface 6 of the recessed structure 5. That is, as long as the etching process is continued, the bottom surface 6 of the recessed structure 5 remains in contact with the catalyst material 3. As a result, the bottom surface 6 of the recessed structure 5 continues to be etched through the aforementioned reaction mechanism, and the bottom surface 6 continues to move in the depth direction.

Meanwhile, in terms of the side walls 7 of the recessed structure 5, once the etching is started, the etching reaction proceeds in the portions of the side walls 7 that are in contact with the catalyst material 3 through the aforementioned mechanism. More precisely, only the portions of the process target 1 that are in contact with the side surfaces of the catalyst material 3 are etched. As a result, at the portions in contact with the side surfaces of the catalyst material 3, a recessed structure 5 defined by the side walls 7 is formed.

However, since the catalyst material 3 continues to descend to a deeper position, as of a certain point, the upper portions of the side walls 7 are no longer in contact with the side surfaces of the catalyst material 3. Hereinafter, the side walls 7 which have become out of contact with the side surfaces of the catalyst material 3 are referred to as the "first side wall portions 7a".

Here, as described above, etching hardly proceeds at the portions on which the catalyst material 3 does not exist, such as the uncoated region 8b. In other words, the etching reaction occurs only when the process target 1 is in contact with the catalyst material 3 and does not occur in any other state. For this reason, the etching process is substantially stopped at the portions of the side walls 7 that have once become out of contact with the catalyst material

3, such as the first side wall portion 7a.

This feature is a critical difference from the dry etching method such as the existing RIE method. That is, in the RIE method, regions that have already been etched to a complete state, such as the regions near the opening in the surface of the process target, still continue to be exposed to the reaction gas for as long as the etching process. Therefore, the possibility that a recessed structure having a tapered shape will be formed increases due to the continuation of the etching process.

In the etching process of the present invention, etching of the process target 1 selectively proceeds only exactly under the catalyst material 3, and a perpendicular recessed structure can ultimately be formed as a result of such an etching stop mechanism at the first side wall portions 7a that are not in contact with the catalyst material 3.

Under the above effect, the etching process of the present invention can form a characteristic perpendicular recessed structure as the recessed structure 5.

The etching process of the present invention further has the following additional effects.

(I) A deep recessed structure can be formed.

The existing RIE method has a limit on the etching depth in $SiO_2$. For example, when a photoresist is used as a mask agent, it is difficult to form a deep recessed structure having a depth of, e.g., 20 μm.

In contrast, in the etching process of the present invention, the etching reaction proceeds as long as the fluorine-containing gas continues to be supplied to the coated region. Therefore, a recessed structure having a high aspect ratio can be formed. For example, an aspect ratio of 10 or greater can be realized.

The "aspect ratio" means the dimension in the depth direction relative to the minimum dimension of the opening in the recessed structure.

(II) Etching can be performed rapidly.

The existing RIE method has a processing speed of approximately 1 μm/min or less, and cannot be said to be a sufficiently rapid microfabrication technique.

As compared, the etching process of the present invention enables etching of 3.0 μm/min or higher through, for example, increasing either or both of the amount of the catalyst material set and the amount of the fluorine-containing gas supplied. Therefore, the etching process of the present invention can be used as a rapid recessed structure forming technique.

(Method of manufacturing a member having a recessed structure according to an embodiment of the present invention)

Next, with reference to FIGS. 7 to 9, a method of manufacturing a member having a recessed structure according to an embodiment of the present invention will be described in more detail.

FIG. 7 illustrates the outline of the flow of the method of manufacturing a member having a recessed structure according to an embodiment of the present invention (hereinafter simply referred to as the "first method").

As illustrated in FIG. 7, the first method includes:

(1) a step of providing a process target having a first surface, wherein the first surface is made of an element that forms a fluoride having a boiling point of 550°C or less (S110);
(2) a step of setting a catalyst material on a portion of the first surface of process target, wherein the catalyst material is an organic compound containing a polar functional group (S120); and
(3) a step of exposing the process target to a fluorine-containing gas at 80°C or higher (S130).

Each step will be described below.

(Step S110)

First, the process target is prepared.

The process target may be formed of a single member or a plurality of members.

When the process target is formed of a single member, the process target is made of an element that forms a fluoride having a boiling point of 550°C or less through a reaction with fluorine (F).

For example, the process target may contain at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au. The process target may also contain at least one element selected from the group consisting of H, N, Cl, Br, and O.

In particular, it is preferable that the process target is made of an element that forms a fluoride having a boiling point of 200°C or less through a reaction with fluorine.

For example, a fluoride $SiF_4$ of silicon (Si) has a boiling point of -86°C, and a process target containing silicon can be suitably used as a process target of the first method.

A fluoride ($AlF_3$) of Al and a fluoride ($CaF_2$) of Ca both have a boiling point higher than 550°C. Therefore, Al and Ca are not elements that form fluorides having a boiling point of 550°C or less through a reaction with fluorine (F).

The process target may be, for example, a silica glass substrate, a crystal substrate, or a silicon substrate.

On the other hand, when the process target is formed of a laminate of a plurality of members, the process target contains an element that forms a fluoride having a boiling point of 550°C or less in the topmost surface (hereinafter referred to as the "first surface").

As described above, such an element may be selected from the group consisting of, for example, B, C, Si, P, S, Ti, V, Cr, Ge, As, Se, Nb, Mo, Tc, Ru, Rh, Sn, Sb, Te, I, Ta, W, Re, Os, Ir, Pt, and Au. The first surface may also further contain at least one element selected from the group consisting of H, N, Cl, Br, and O.

For example, the process target may have one or more films that are placed on a substrate, and the topmost film may satisfy the aforementioned feature. Alternatively, the entirety of the plurality of films may satisfy the aforementioned feature.

Such films may contain, for example, at least one selected from $SiO_2$, $Si_3N_4$, and SiC.

Alternatively, the substrate may also have the aforementioned feature together with the films. In this case, the first method can manufacture a member in which a recessed structure is formed into the substrate as well. The substrate may be, for example, a silica glass substrate, a crystal substrate, or a silicon substrate.

In the following description, in order to avoid complexity, it is assumed that the process target is made of a single type of silica glass, and a recessed structure is formed in the first surface of the silica glass.

(Step S120)

Next, the catalyst material is set on the first surface of the process target. The catalyst material is set on a predetermined region of the first surface.

The catalyst material contains an organic compound containing a polar functional group. The polar functional group may include, for example, at least one selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

Representative examples of such organic compounds are, for example, phenolic resins, acrylic resins, and methacrylic resins.

The catalyst material may be made solely of the organic compound containing the aforementioned polar functional group or may be provided as a mixture with other additives.

In the latter case, the catalyst material may contain either one or any combinations selected from a solvent, a binder, and fine particles, etc.

The method of setting the catalyst material is not particularly limited.

The catalyst material may be set on the first surface of the process target using, for example, a coating method, a printing method, a spin coating method, or a spray method.

FIG. 8 exemplarily illustrates how the catalyst material is set on the process target.

As illustrated in FIG. 8, the process target 110 has a first surface 112 and a second surface 114. The catalyst material 130 is set on some portions of the first surface 112 of the process target 110.

In the example illustrated in FIG. 8, the catalyst material 130 is set in the form of a plurality of parallel linear patterns 131. However, this is only an example, and the catalyst material 130 may be set in any form depending on the required recessed structure. The catalyst material 130 may be set, for example, in the form of one straight line. Alternatively, the catalyst material 130 may be set, for example, in the form of a round dot pattern or a single round dot.

The thickness of the catalyst material 130 is not particularly limited, but may range, for example, from 0.1 um through 4 um. As defined above, the region of the first surface 112 on which the catalyst material 130 is set is referred to as the coated region 140a, and any other region is referred to as the uncoated region 140b.

(Step S130)

Next, the process target 110 on which the catalyst material 130 is set is housed in the processing chamber. Thereafter, for etching the process target, the inside of the processing chamber is heated to a predetermined temperature and the processing gas is supplied.

The processing gas includes hydrogen fluoride gas or fluorine gas. For example, the processing gas may be adjusted to a predetermined concentration by a carrier gas such as argon gas or nitrogen gas. In this case, the concentration of the hydrogen fluoride gas or the fluorine gas may range from, for example, 0.1 vol% through 100 vol%.

As described above, the processing temperature is 80°C or higher. The actual processing temperature varies

depending on the elements contained in the process target 110 (in particular, the first surface 112) and the type and depth of the recessed structure, and the like. In the usual case, the processing temperature is in the range of 200°C through 450°C and preferably 250°C through 400°C. By setting the processing temperature to 450°C or lower, the denaturation of the organic compound contained in the catalyst material 130 can be inhibited.

As described above, the etching process of the process target 110 under such an environment produces a reaction of the formula (2) in the coated region 140a. The fluoride and water produced by the reaction escape the system in the form of gases. As a result, a recessed structure is formed in the coated region 140a of the first surface 112.

The recessed structure may be a bottomed structure or a through structure. The bottomed structure may be, for example, either or both of a bottomed hole and a bottomed groove. The through structure may be a through hole or a through groove.

FIG. 9 exemplarily illustrates an example of a cross section of the process target 110 after being etched.

In the example illustrated in FIG. 9, the recessed structures 150 are formed of a plurality of grooves, and the grooves extend in parallel with each other in a top view. In this example, each groove extends from the first surface 112 in the depth direction, but does not reach the second surface 114, and is therefore a bottomed groove.

After the step S130, a step of removing the catalyst material 130 remaining on the bottom surface of the recessed structure 150 may be performed. For example, the catalyst material 130 may be removed by cleaning the process target 110 with an acid solution, an alkaline solution, an organic solvent, a corrosive gas or plasma.

By the above steps, a member 100 having a recessed structure 150 in the first surface 112 can be manufactured.

(Member having recessed structures according to an embodiment of the present invention)

Next, referring to FIGS. 10 to 13, a member having recessed structures according to an embodiment of the present invention will be described.

FIG. 10 illustrates a perspective view of a member (hereinafter referred to as "first member 200") having recessed structures according to an embodiment of the present invention. FIG. 11 illustrates an exemplary cross-sectional view of the first member 200 along a line A-A of illustrated in FIG. 10.

As illustrated in FIG. 10, the first member 200 has a first surface 202 and a second surface 204 facing each other. The first member 200 also has recessed structures 250 on the side of the first surface 202.

In the example illustrated in FIG. 10, the first surface 202 and the second surface 204 of the first member 200 are approximately rectangular. However, the shape of the first surface 202 and the second surface 204 is not particularly limited.

In the example illustrated in FIG. 10, the recessed structures 250 have the shape of a bottomed groove extending in one direction, and the three recessed structures 250 are arranged in parallel.

However, this is only an example, and the shape and arrangement of the recessed structures 250 are not particularly limited. For example, the recessed structures 250 may be a bottomed structure or a through structure. The bottomed structure may be, for example, either or both of a bottomed hole and a bottomed groove. The through structure may be a through hole or a through groove. Similarly, the pattern of the recessed structures 250 may be any form.

As illustrated in FIG. 11, the recessed structures 250 have an opening 252 in the first surface 202. The recessed structures 250 also have a bottom surface 256 and side walls 257. In other words, the recessed structures 250 are defined by an opening 252, a bottom surface 256, and side walls 257.

The first member 200 may be manufactured, for example, by the first method described above.

Here, the first member 200 has a characteristic of having a streak pattern along the depth direction on the side wall 257.

This characteristic will be described below with reference to FIG. 12.

FIG. 12 exemplarily illustrates a surface configuration of the side wall 257 of the recessed structure 250. FIG. 12 exemplarily illustrates a portion of the side wall 257 obtained when the recessed structure 250 is cut through an extension axis in the direction along the first surface 202 and an extension axis in the depth direction of the first member 200.

As illustrated in FIG. 12, in the first member 200, the side wall 257 of the recessed structure 250 has uninterrupted continuous streaks (hereinafter referred to as "continuous streaks") 280 extending from the first opening 252 to the bottom surface 256.

In FIG. 12, three continuous streaks 280 are illustrated. However, this is only an example, and the number of continuous streaks 280 is not particularly limited.

This pattern of continuous streaks 280 is significant and is not observed in members etched by the existing manner. That is, continuous streaks 280 are characteristic features observed in the first member 200 manufactured by the first method as described above.

The pattern of the continuous streaks 280 is considered to be formed for the following reasons.

As described above with reference to FIGS. 5 and 6, in the first method, the coated region 8a is selectively

etched by the catalyst material 3 set on the coated region 8a. Further, as long as the relationship between the catalyst material 3 and the coated region 8a continues, the recessed structure 5 continues to grow in the depth direction.

In the case of such an etching mechanism, the side walls 7 of the recessed structure 5 produced by etching are affected by the state of the side surfaces of the catalyst material 3 with which the side walls 7 are in contact.

That is, when the side surfaces of the catalyst material 3 have undulations, it is considered that the side walls 7 of the recessed structure 5 have a surface state having corresponding undulations, reflecting the effect of the undulations of the side surfaces of the catalyst material 3.

In the first method, the catalyst material 3 having such undulations on the side surfaces moves to the bottom surface 6 of the recessed structure 5 along the depth direction of the recessed structure 5. Therefore, it is considered that a pattern of continuous streaks 280 corresponding to such undulations is formed on the side walls 7 of the recessed structure 5 ultimately obtained.

In addition to or apart from the above features, the first member 200 may have a feature that the taper angle θ of the recessed structure 5 ranges from 0° to 2°.

This feature will be described below with reference to FIG. 13.

FIG. 13 exemplarily illustrates a cross section of a certain recess along the extension axis L.

The recess 50 has an opening 52 in the first surface of the member. The recess 50 has a bottom surface 56 and side walls 57.

Although it is not clear from FIG. 13, the recess 50 may have a round hole shape or a rectangular groove shape in a top view. The recess 50 may have a through structure. In this case, the recess 50 may have a second opening instead of the bottom surface 56.

Regarding such a recess 50, the taper angle θ is defined as follows:

[Math. 2]

$$\text{Taper angle } \theta\ (°) = \cos^{-1}\left(\frac{c}{\sqrt{\left(\frac{a-b}{2}\right)^2 + c^2}}\right)$$

Equation (1)

where a is the minimum dimension of the opening 52, b is the minimum dimension of the bottom surface 56, c is the distance between the first opening 52 and the bottom surface 56, that is, the depth of the recess 50.

The taper angle θ represented by the equation (1) is an index of the "perpendicularity" of the recess 50. That is, the smaller the taper angle θ, the more the inclination of the side walls 57 of the recess 50 with respect to the extension axis L is suppressed, and therefore, the recess 50 can be regarded as being close to the "perpendicular recessed structure". In particular, when the taper angle θ of the recessed structure 250 is in the range of 0° to 2° in the first member 200, the recessed structure 250 can be regarded as having a perpendicular recessed structure.

In the first member 200, the taper angle θ of the recessed structure 250 may be 1° or less.

In the first member 200, the depth of the recessed structure 250 may be 1 um or more. In particular, in the first member 200, the depth of the recessed structure 250 is, for example, 2 um or more, and preferably 3 um or more.

(Other features of the first member 200)

The first member 200 may be a single member or may be formed of a plurality of members.

When the first member 200 is formed of a single member, the first member 200 is made of an element that forms a fluoride having a boiling point of 550°C or less through a reaction with fluorine (F).

For example, the first member 200 may contain at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au. The process target may also contain at least one element selected from the group consisting of H, N, Cl, Br, and O.

In a case where the first member 200 is formed of a single member, the first member 200 may be, for example, a silica glass substrate or a crystal substrate.

On the other hand, in a case where the first member 200 is formed of a plurality of members, the first member 200 contains an element that forms a fluoride having a boiling point of 550°C or less in the first surface 202.

As described above, such an element may be selected from the group consisting of, for example, B, C, Si, P, S, Ti, V, Cr, Ge, As, Se, Nb, Mo, Tc, Ru, Rh, Sn, Sb, Te, I, Ta, W, Re, Os, Ir, Pt, and Au. Also, the first surface 202 may further contain at least one element selected from the group consisting of H, N, Cl, Br, and O.

For example, the first member 200 may have 1 or 2 or more films placed on the substrate material, with the

topmost film satisfying the aforementioned feature. Alternatively, the entirety of the plurality of films may satisfy the aforementioned feature.

Such films may contain, for example, at least one selected from $SiO_2$, $Si_3N_4$, and SiC. Alternatively, the substrate material may also have the aforementioned feature together with the films.

The first member 200 having these features may be applied to a variety of applications, including, for example, MEMS devices, microfluidic devices, semiconductor devices, optical devices, metasurface devices, molds for resin molding, window glass, and cover glass.

Examples

Examples of the present invention will be described below.

In the following description, Examples 1 to 7 and Examples 11 to 12 are examples, and Example 21 is a comparative example.

(Example 1)

A recessed structure was formed in one surface (first surface) of a process target by the following method.

First, a substrate made of silica glass was prepared as the process target. In addition, a coating liquid containing a catalyst material was prepared. The coating liquid was prepared by using an i-line resist as the catalyst material and mixing it with a solvent (ethyl lactate, acetic acid-n-butyl).

The i-line resist used contains a novolac resin represented by the following chemical formula.

[Chem. 1]

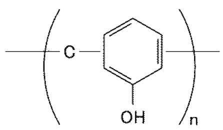

Accordingly, the i-line resist has a hydroxy group as a polar functional group.

Next, a coating liquid was set on the first surface of the substrate by the spin coating method. Furthermore, a pattern of the catalyst material was set on the first surface of the substrate by an exposure and development process. The pattern was a parallel line pattern with a width of approximately 10 μm and a pitch of approximately 30 μm.

Next, the substrate on which the pattern of the catalyst material was set was cut into dimensions of approximately 20 mm × approximately 20 mm, and the cut sample was placed in the processing chamber. In addition, gas etching of the sample was performed in the processing chamber. A mixture of nitrogen gas and hydrogen fluoride gas ($HF/N_2$ = 20 vol%) was used as the processing gas. The processing temperature was set to 250°C.

The process target obtained through the etching process is referred to as "sample 1 ".

It was confirmed that a plurality of parallel extending grooves were formed as recessed structures in the first surface of Sample 1.

(Examples 2 to 4)

Recessed structures were formed in the first surface of a substrate by the same method as in Example 1. However, in Examples 2 to 4, the recessed structures were formed by changing the process conditions of the etching process from those in Example 1.

The process targets obtained through the etching process are referred to as "Sample 2" to "Sample 4", respectively.

It was confirmed that a plurality of parallel extending grooves were formed as recessed structures in the first surface of Samples 2 to 4.

(Examples 5 to 6)

Recessed structures were formed in the first surface of a substrate by the same method as in Example 1. However, in Examples 5 and 6, the recessed structures were formed by changing the type of the catalyst material and the etching conditions from those in Example 1. In Examples 5 and 6, an EB resist was used as the catalyst material.

The EB resist contains an organic compound represented by the following chemical formula.

[Chem. 2]

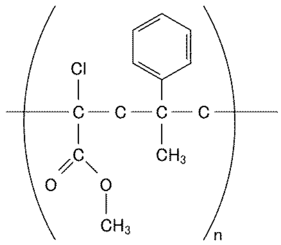

Accordingly, the EB resist has an ester bond as a polar functional group.
The process targets obtained through the etching process are referred to as "Sample 5" and "Sample 6", respectively.
It was confirmed that a plurality of parallel extending grooves were formed as recessed structures in the first surface of Sample 5 and Sample 6.

(Example 7)

Recessed structures ware formed in the first surface of the substrate by the same method as in Example 1. However, in Example 7, the recessed structures were formed by changing the type of process target and the etching conditions from those in Example 1. A crystal substrate (AT-cut) was used as the process target.
The process target obtained through the etching process is referred to as "Sample 7".
It was confirmed that a plurality of parallel extending grooves were formed as recessed structures in the first surface of Sample 7.

(Example 11)

Recessed structures were formed in the first surface of the substrate by the same method as in Example 1. However, in Example 11, the recessed structures were formed by changing the type of process target and the etching conditions from those in Example 1. As the process target, a Si wafer having a natural oxide film on the first surface was used.
The process target obtained through the etching process is referred to as "sample 11".
It was confirmed that a plurality of parallel extending grooves were formed as recessed structures in the first surface of Sample 11.

(Example 12)

Recessed structures were formed in the first surface of the substrate by the same method as in Example 1. However, in Example 12, the recessed structures were formed by changing the type of process target and the etching conditions from those in Example 1. The process target was prepared by forming a $SiO_2$ film having a thickness of approximately 5 um on the first surface of a glass substrate by a sputtering method.
The process target obtained through the etching process is referred to as "Sample 12".
It was confirmed that a plurality of parallel extending grooves were formed as recessed structures in the first surface of Sample 12.

(Example 13)

Recessed structures were formed in the first surface of a substrate by the same method as in Example 1. However, in Example 13, the recessed structures were formed by changing the type of the process target and the etching conditions from those in Example 1. The process target was prepared by forming a $SiO_2$ film having a thickness of approximately 30 um on the first surface of a glass substrate by CVD.
The process target obtained through the etching process is referred to as "Sample 13".
It was confirmed that a plurality of parallel extending grooves were formed as recessed structures in the first surface of Sample 13.

(Example 14)

Recessed structures were formed in the first surface of a substrate by the same method as in Example 1. However, in Example 14, the recessed structures were formed by changing the type of the process target and the etching conditions from those in Example 1. A bulk of $SiO_2$ composition produced by the particle sintering method was used as the process target.

The process target obtained through the etching process is referred to as "Sample 14".

It was confirmed that a plurality of parallel extending grooves were formed as recessed structures in the first surface of Sample 14.

(Example 21)

Recessed structures were formed in one surface (the first surface) of a process target by the ICP-RIE method in the manner described below.

A substrate made of the same silica glass as that of Example 1 was used as the process target.

A parallel line-shaped mask pattern with a thickness of approximately 7 μm was formed on the first surface of the substrate by a three-layer resist process.

Next, the first surface of the substrate was etched by the ICP-RIE method. As a result, regions of the first surface on which no resist pattern was set were etched, forming a plurality of parallel extending grooves.

The process target obtained through the processing is referred to as "Sample 21" .

Table 1 below collectively indicates the preparation conditions of the samples.

[Table 1]

| Sample | Process target | Organic compound | Polar functional group | Processing temperature (°C) |
|---|---|---|---|---|
| 1 | Silica glass | i-line resist | Hydroxy group | 250 |
| 2 | Silica glass | i-line resist | Hydroxy group | 250 |
| 3 | Silica glass | i-line resist | Hydroxy group | 350 |
| 4 | Silica glass | i-line resist | Hydroxy group | 350 |
| 5 | Silica glass | EB resist | Ester bond | 250 |
| 6 | Silica glass | EB resist | Ester bond | 250 |
| 7 | Crystal substrate (AT-cut) | i-line resist | Hydroxy group | 250 |
| 11 | Si substrate + natural oxide film | i-line resist | Hydroxy group | 350 |
| 12 | Glass substrate + $SiO_2$ film | i-line resist | Hydroxy group | 350 |
| 13 | Glass substrate + $SiO_2$ film | i-line resist | Hydroxy group | 250 |
| 14 | $SiO_2$ sintered body | i-line resist | Hydroxy group | 250 |
| 21 | Silica glass | RIE process | | |

(Evaluation)

The cross-section of the recessed structures of each sample was observed by a scanning electron microscope (SEM), and the dimensions were measured. In addition, the presence or absence of continuous streaks on the side walls of the recessed structures was evaluated.

FIGS. 14 to 18 illustrate examples of cross sections of the recessed structures obtained in Sample 1, Sample 4, Sample 7, Sample 13, and Sample 21, respectively.

From these images, it can be seen that perpendicular recessed structures with significantly reduced taper angles were formed as recessed structures in Sample 1, Sample 4, Sample 7, and Sample 13.

FIG. 19 illustrates an example of the side wall configuration of the recessed structure obtained in Sample 4.

It can be seen from FIG. 19 that a plurality of continuous streaks, which were continuous from the first surface to the bottom surface of the recess without interruption, were formed on the side walls of the recessed structure. This configuration was also observed in Samples 1 to 3, Samples 5 to 7, and Samples 13 to 14.

The results obtained for each sample are collectively indicated in Table 2.

[Table 2]

| Sample | Depth of recess (μm) | Taper angle θ (°) | Continuous streak |
|---|---|---|---|
| 1 | 13.4 | 0 | Present |
| 2 | 23 | 0 | Present |
| 3 | 4.3 | 0 | Present |
| 4 | 33.8 | 0.17 | Present |
| 5 | 3.2 | 0 | Present |
| 6 | 0.9 | 0 | Present |
| 7 | 2.6 | 0 | Present |
| 11 | 0.04 | Not measured | Not measured |
| 12 | 1.3 | Not measured | Not measured |
| 13 | 3.0 | 0 | Present |
| 14 | - | 0 | Present |
| 21 | 21 | 4.06 | Absent |

From these results, it was found that in Sample 21, the taper angle θ of the recessed structure was relatively large, being 4° or more, meaning that a tapered shape was formed.

In contrast, in Samples 1 to 7 and Samples 13 to 14, the recessed structures had no tapered shape and perpendicular recessed structures were formed.

In addition, it was confirmed that continuous streaks were formed at least in Samples 1 to 7 and Samples 13 to 14.

(One aspect of the present invention)

The present invention may have the following aspects.

(Aspect 1)

A method of manufacturing a member having a recessed structure, the method including:

(1) setting a catalyst material on a portion of a first surface of a process target, wherein the first surface is made of an element that forms a fluoride having a boiling point of 550°C or less, and the catalyst material contains an organic compound containing a polar functional group; and
(2) exposing the process target to a fluorine-containing gas at 80°C or higher,

wherein through the (2), the recessed structure is formed in the first surface under the catalyst material.

(Aspect 2)

The method according to Aspect 1, wherein the polar functional group includes at least one selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

(Aspect 3)

The method according to Aspect 1 or 2,
wherein the fluorine-containing gas is hydrogen fluoride gas or fluorine gas.

(Aspect 4)

The method according to any one of Aspects 1 to 3,

wherein the (2) is performed in a range of from 200°C through 450°C.

(Aspect 5)

The method according to any one of Aspects 1 to 4,
wherein the first surface contains at least one element selected from the group consisting of H, B, C, N, O, Si, P, S, Cl, Ti, V, Cr, Ge, As, Se, Br, Nb, Mo, Tc, Ru, Rh, Sn, Sb, Te, I, Ta, W, Re, Os, Ir, Pt, and Au.

(Aspect 6)

The method according to any one of Aspects 1 to 5,
wherein the recessed structure includes either or both of a bottomed structure and a through structure.

(Aspect 7)

The method according to Aspect 6,
wherein the recessed structure is at least one selected from a bottomed hole, a through hole, a bottomed groove, and a through groove.

(Aspect 8)

The method according to any one of Aspects 1 to 7,
wherein the process target is formed of a single member.

(Aspect 9)

The method according to Aspect 8,
wherein the process target is a silica glass substrate, a crystal substrate, or a sintered body of silica particles.

(Aspect 10)

The method according to any one of Aspects 1 to 7,
wherein the process target includes one, or two or more layers.

(Aspect 11)

The method according to Aspect 10,
wherein the process target includes a substrate and a film disposed on the substrate, and the film contains at least one selected from $SiO_2$, SiN, and SiC, and constitutes the first surface.

(Aspect 12)

A member, including:

a recessed structure in a first surface,
wherein the recessed structure is either or both of a bottomed structure and a through structure,
the first surface contains at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recessed structure is defined by a first opening formed in the first surface, surrounding side walls, and a bottom surface or a second opening, and
the side walls have at least one streak extending from the first opening to the bottom surface or the second opening.

(Aspect 13)

The member according to Aspect 12,
wherein the first surface further contains at least one selected from the group consisting of H, N, Cl, Br, and O.

(Aspect 14)

The member according to Aspect 12 or 13,

wherein when a minimum dimension of the first opening is a, a minimum dimension of the bottom surface of the recessed structure is b, a depth of the recessed structure is c, and an angle θ represented by an equation (1) below is referred to as a taper angle,
the taper angle θ is $0° \leq \theta \leq 2°$,
[Math. 3]

$$\text{Taper angle } \theta\ (°) = \cos^{-1}\left(\frac{c}{\sqrt{\left(\frac{a-b}{2}\right)^2 + c^2}}\right)$$

Equation (1).

(Aspect 15)

The member according to any one of Aspects 12 to 14,
wherein the recessed structure is at least one selected from a bottomed hole, a through hole, a bottomed groove, and a through groove.

(Aspect 16)

The member according to any one of Aspects 12 to 15,
wherein the member is formed of a single member.

(Aspect 17)

The member according to Aspect 16,
wherein the member is a silica glass substrate, a crystal substrate, or a sintered body of silica particles.

(Aspect 18)

The member according to any one of Aspects 12 to 15,
wherein the member includes one, or two or more layers.

(Aspect 19)

The member according to Aspect 16,
wherein the member includes a substrate and a film disposed on the substrate, the film contains at least one selected from $SiO_2$, SiN, and SiC, and constitutes the first surface.

(Aspect 20)

A member, including:

a recessed structure in a first surface,
wherein the recessed structure is either or both of a bottomed structure and a through structure,
the first surface contains at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recessed structure has a depth of 1 um or greater, and has a first opening formed in the first surface, and a bottom surface or a second opening, and
when a minimum dimension of the first opening is a, a minimum dimension of the bottom surface or the second opening of the recessed structure is b, a depth of the recessed structure is c, and an angle θ represented by an equation (1) below is referred to as a taper angle,

the taper angle θ is $0° \leq \theta \leq 1°$
[Math. 4]

$$\text{Taper angle } \theta\ (°) = \cos^{-1}\left(\frac{c}{\sqrt{\left(\frac{a-b}{2}\right)^2 + c^2}}\right)$$

Equation (1).

(Aspect 21)

The member according to Aspect 20, wherein the first surface further contains at least one selected from the group consisting of H, N, Cl, Br, and O.

(Aspect 22)

The member according to Aspect 20 or 21, wherein the member is formed of a single member.

(Aspect 23)

The member according to Aspect 22, wherein the member is a silica glass substrate, a crystal substrate, or a sintered body of silica particles.

(Aspect 24)

The member according to Aspect 20 or 21, wherein the member includes one, or two or more layers.

(Aspect 25)

The member according to Aspect 23,

wherein the member includes a substrate and a film disposed on the substrate, and
the film contains at least one selected from $SiO_2$, SiN, and SiC, and constitutes the first surface.

This application claims priority to Japanese Patent Application No. 2021-210305 filed December 24, 2021, the entire contents of which are incorporated herein by reference.

Reference Signs List

| | |
|---|---|
| 1 | process target |
| 3 | catalyst material |
| 5 | recessed structure |
| 6 | bottom surface |
| 7 | side wall |
| 7a | first side wall portion |
| 8a | coated region |
| 8b | uncoated region |
| 50 | recess |
| 52 | opening |
| 56 | bottom surface |
| 57 | side wall |
| 100 | member |

| | |
|---|---|
| 110 | process target |
| 112 | first surface |
| 114 | second surface |
| 130 | catalyst material |
| 131 | pattern |
| 140a | coated region |
| 140b | uncoated region |
| 150 | recessed structure |
| 200 | first member |
| 202 | first surface |
| 204 | second surface |
| 250 | recessed structure |
| 252 | opening |
| 256 | bottom surface |
| 257 | side wall |
| 280 | continuous streak |
| (a) | HF molecule |
| (b) | Si atom |
| (c) | OH group |
| (d) | Si-F bond |
| (e) | -δ moiety |
| (f) | +δ moiety |
| (g) | $H_2O$ molecule |

## Claims

**1.** A method of manufacturing a member having a recessed structure, the method comprising:

(1) setting a catalyst material on a portion of a first surface of a process target, wherein the first surface is made of an element that forms a fluoride having a boiling point of 550°C or less, and the catalyst material comprises an organic compound containing a polar functional group; and
(2) exposing the process target to a fluorine-containing gas at 80°C or higher,

wherein through the (2), the recessed structure is formed in the first surface under the catalyst material.

**2.** The method according to claim 1,
wherein the polar functional group comprises at least one selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

**3.** The method according to claim 1 or 2,
wherein the fluorine-containing gas is hydrogen fluoride gas or fluorine gas.

**4.** The method according to claim 1 or 2,
wherein the (2) is performed in a range of from 200°C through 450°C.

**5.** The method according to claim 1 or 2,
wherein the first surface comprises at least one element selected from the group consisting of H, B, C, N, O, Si, P, S, Cl, Ti, V, Cr, Ge, As, Se, Br, Nb, Mo, Tc, Ru, Rh, Sn, Sb, Te, I, Ta, W, Re, Os, Ir, Pt, and Au.

**6.** The method according to claim 1 or 2,
wherein the recessed structure comprises either or both of a bottomed structure and a through structure.

**7.** The method according to claim 6,
wherein the recessed structure is at least one selected from a bottomed hole, a through hole, a bottomed groove, and a through groove.

**8.** The method according to claim 1 or 2, wherein the process target is formed of a single member.

**9.** The method according to claim 8,
wherein the process target is a silica glass substrate, a crystal substrate, or a sintered body of silica particles.

**10.** The method according to claim 1 or 2,
wherein the process target includes one, or two or more layers.

**11.** The method according to claim 10,

wherein the process target includes a substrate and a film disposed on the substrate, and
the film contains at least one selected from $SiO_2$, SiN, and SiC, and constitutes the first surface.

**12.** A member, comprising:

a recessed structure in a first surface,
wherein the recessed structure is either or both of a bottomed structure and a through structure,
the first surface comprises at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recessed structure is defined by a first opening formed in the first surface, surrounding side walls, and a bottom surface or a second opening, and
the side walls have at least one streak extending from the first opening to the bottom surface or the second opening.

**13.** The member according to claim 12,
wherein the first surface further comprises at least one selected from the group consisting of H, N, Cl, Br, and O.

**14.** The member according to claim 12 or 13,
wherein when a minimum dimension of the first opening is a, a minimum dimension of the bottom surface of the recessed structure is b, a depth of the recessed structure is c, and an angle θ represented by an equation (1) below is referred to as a taper angle, the taper angle θ is $0° \leq \theta \leq 2°$,
[Math. 1]

$$\text{Taper angle } \theta\ (°) = \cos^{-1}\left(\frac{c}{\sqrt{\left(\frac{a-b}{2}\right)^2 + c^2}}\right)$$

Equation (1).

**15.** The member according to claim 12 or 13,
wherein the recessed structure is at least one selected from a bottomed hole, a through hole, a bottomed groove, and a through groove.

**16.** The member according to claim 12 or 13,
wherein the member is made of a single member.

**17.** The member according to claim 16,
wherein the member is a silica glass substrate, a crystal substrate, or a sintered body of silica particles.

**18.** The member according to claim 12 or 13,
wherein the member includes one, or two or more layers.

**19.** The member according to claim 16,

wherein the member includes a substrate and a film disposed on the substrate, and
the film comprises at least one selected from $SiO_2$, SiN, and SiC, and constitutes the first surface.

**20.** A member, comprising:

a recessed structure in the first surface,
wherein the recessed structure is either or both of a bottomed structure and a through structure,
the first surface comprises at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recessed structure has a depth of 1 um or greater, and has a first opening formed in the first surface, and a bottom surface or a second opening, and
when a minimum dimension of the first opening is a, a minimum dimension of the bottom surface or the second opening of the recessed structure is b, a depth of the recessed structure is c, and an angle θ represented by an equation (1) below is referred to as a taper angle, the taper angle θ is 0° ≤ θ ≤ 1°,
[Math. 2]

$$\text{Taper angle } \theta\ (°) = \cos^{-1}\left(\frac{c}{\sqrt{\left(\frac{a-b}{2}\right)^2 + c^2}}\right)$$

Equation (1).

**21.** The member according to claim 20,
wherein the first surface further comprises at least one selected from the group consisting of H, N, Cl, Br, and O.

**22.** The member according to claim 20 or 21,
wherein the member is formed of a single member.

**23.** The member according to claim 22,
wherein the member is a silica glass substrate, a crystal substrate, or a sintered body of silica particles.

**24.** The member according to claim 20 or 21,
wherein the member includes one, or two or more layers.

**25.** The member according to claim 23,

wherein the member includes a substrate and a film disposed on the substrate, and
the film comprises at least one selected from $SiO_2$, SiN, and SiC, and constitutes the first surface.

FIG.1

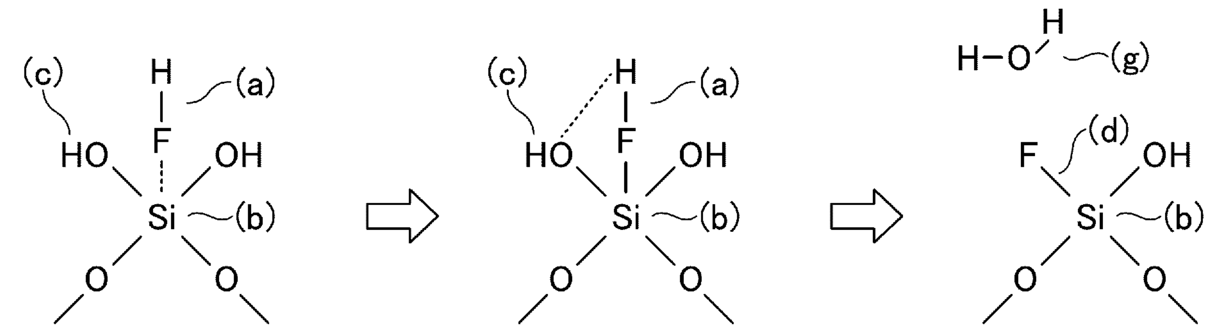

(i) (ii) (iii)

FIG.2

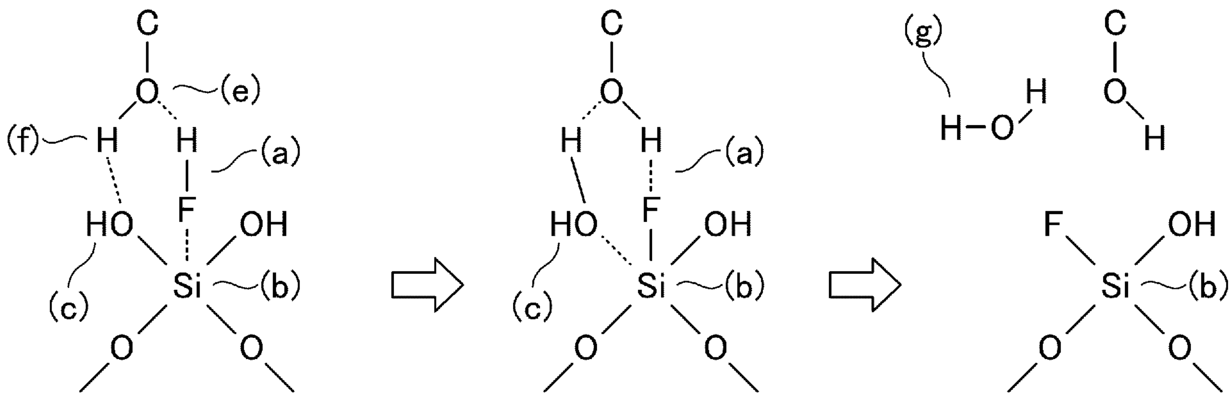

(i) (ii) (iii)

# FIG.3

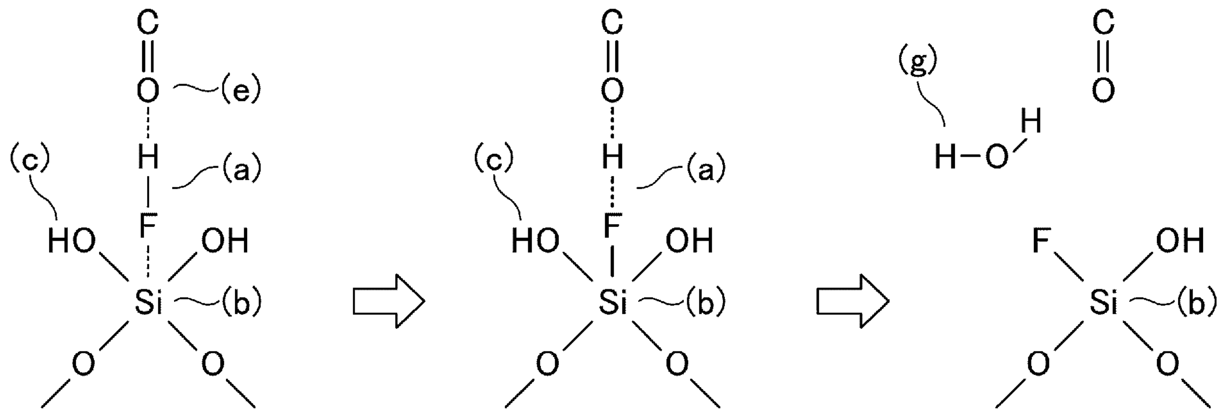

(i) (ii) (iii)

# FIG.4

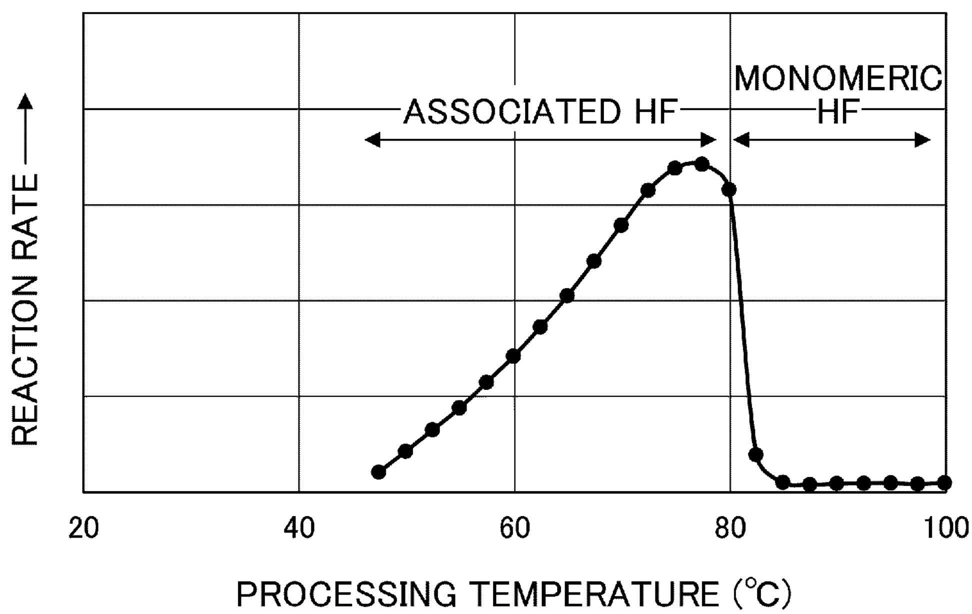

FIG.5

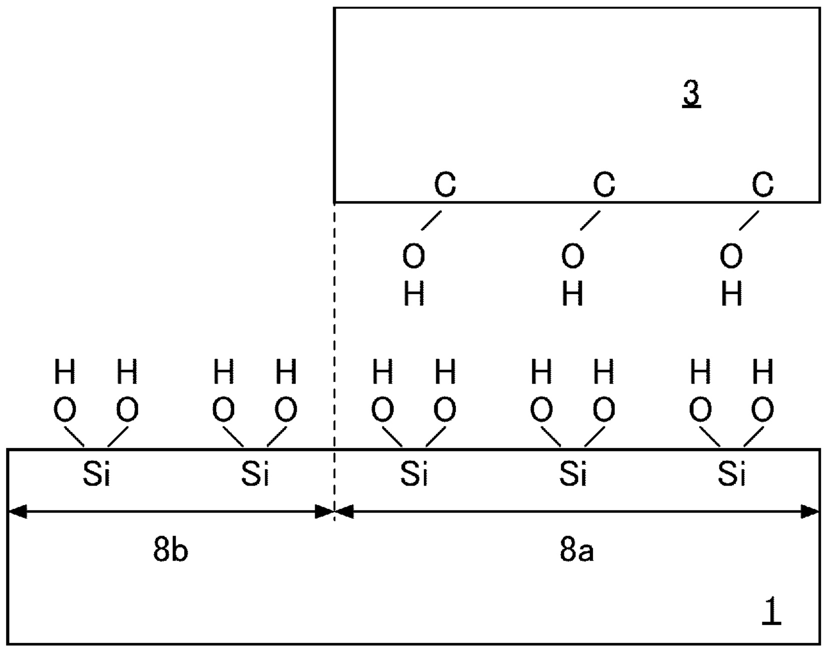

FIG.6

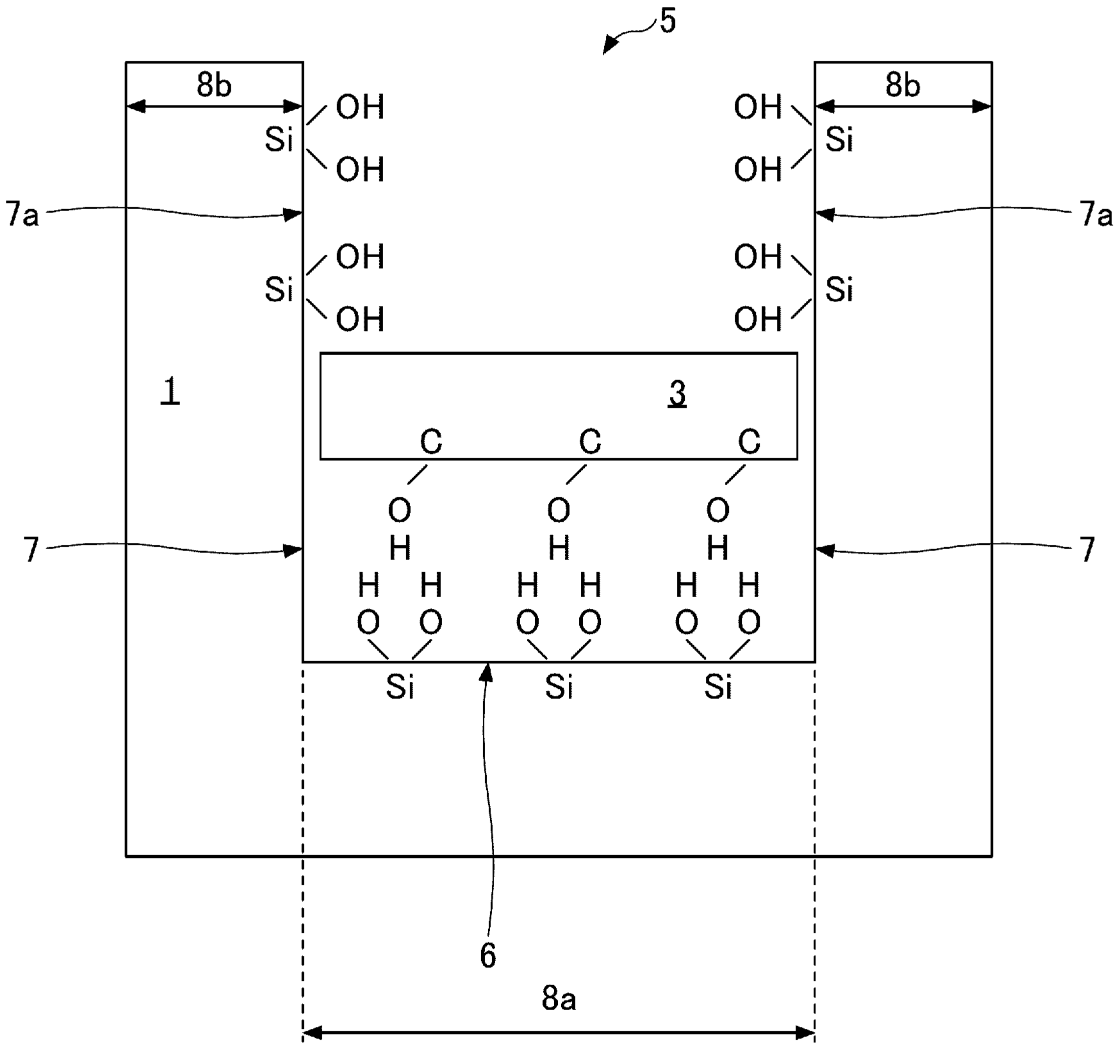

FIG.7

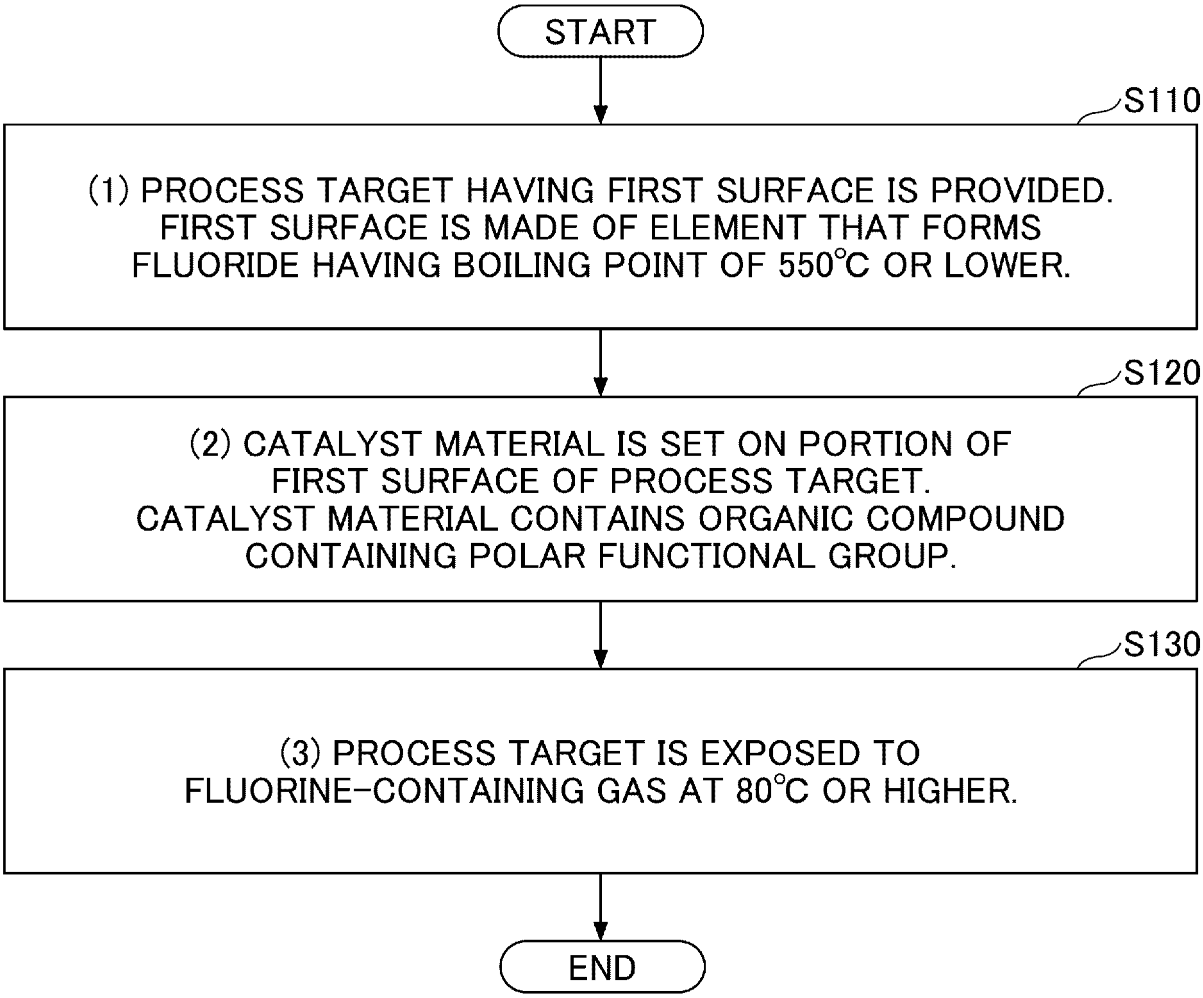
START
S110
(1) PROCESS TARGET HAVING FIRST SURFACE IS PROVIDED. FIRST SURFACE IS MADE OF ELEMENT THAT FORMS FLUORIDE HAVING BOILING POINT OF 550°C OR LOWER.
S120
(2) CATALYST MATERIAL IS SET ON PORTION OF FIRST SURFACE OF PROCESS TARGET. CATALYST MATERIAL CONTAINS ORGANIC COMPOUND CONTAINING POLAR FUNCTIONAL GROUP.
S130
(3) PROCESS TARGET IS EXPOSED TO FLUORINE-CONTAINING GAS AT 80°C OR HIGHER.
END

FIG.8

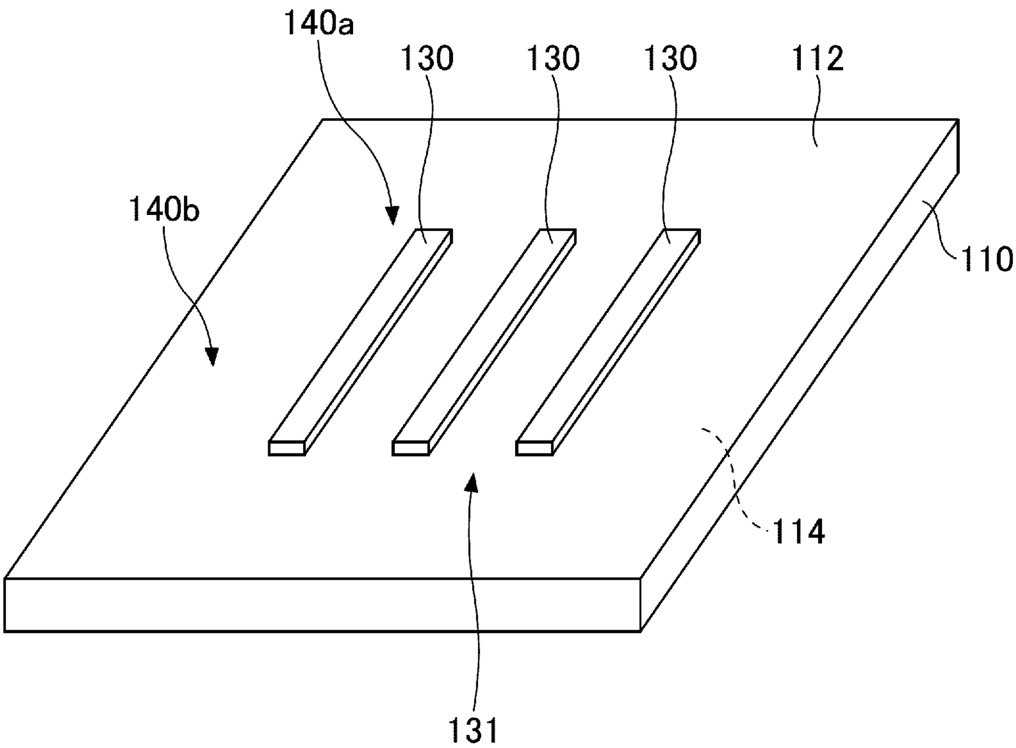
140a
130
130
130
112
140b
110
114
131

FIG.9

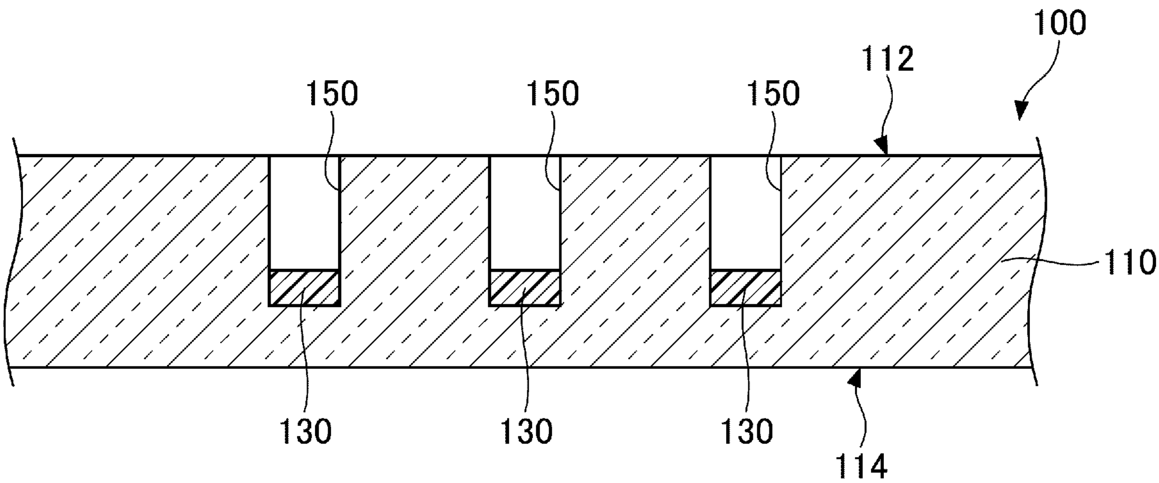
100
112
150
150
150
110
130
130
130
114

FIG.10

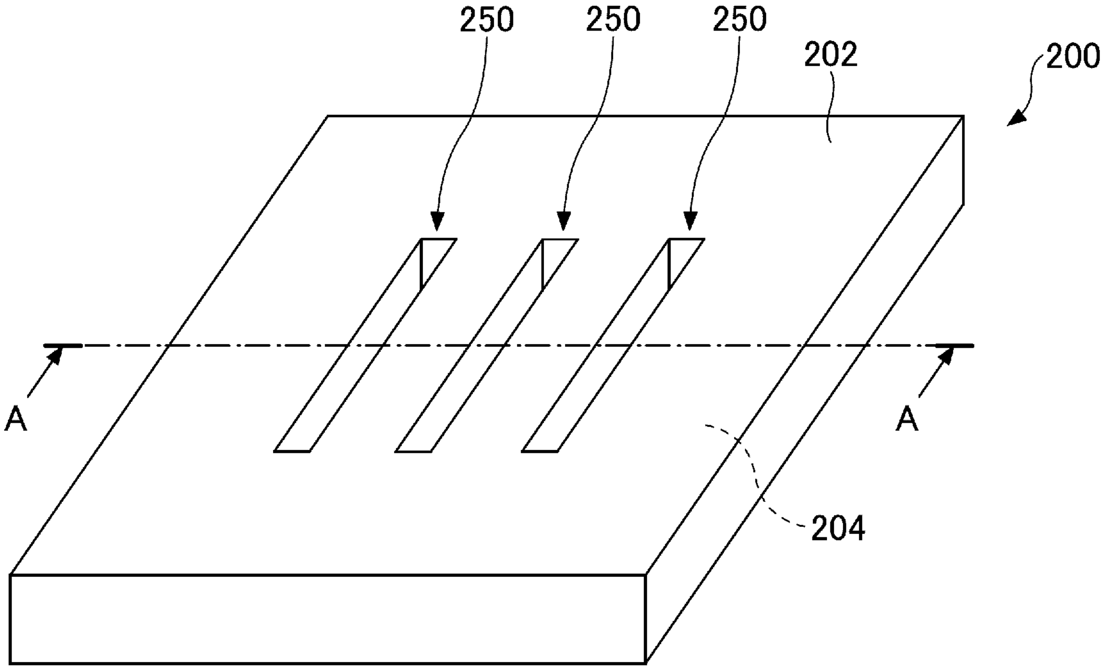
250
250
250
202
200
A
A
204

FIG.11

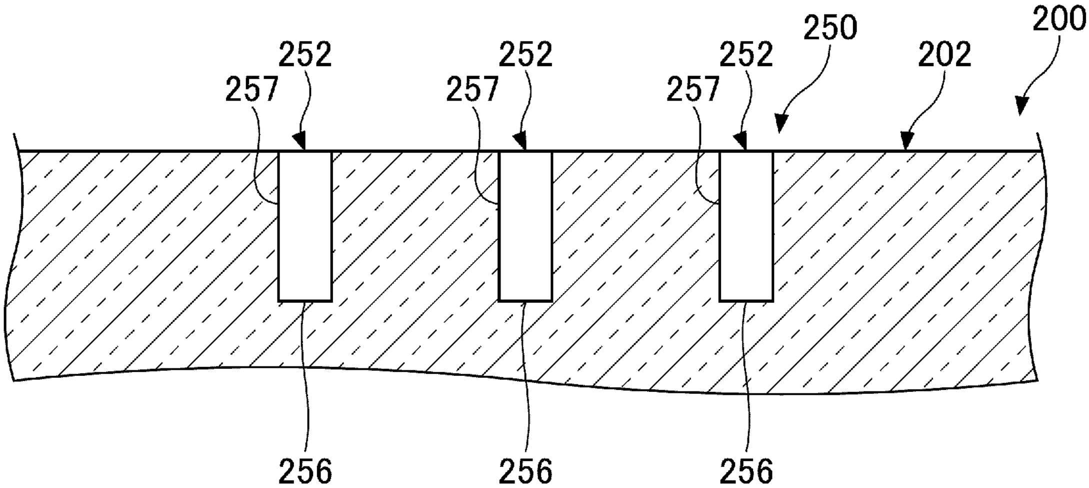
252
257
252
257
252
257
250
202
200
256
256
256

FIG.12

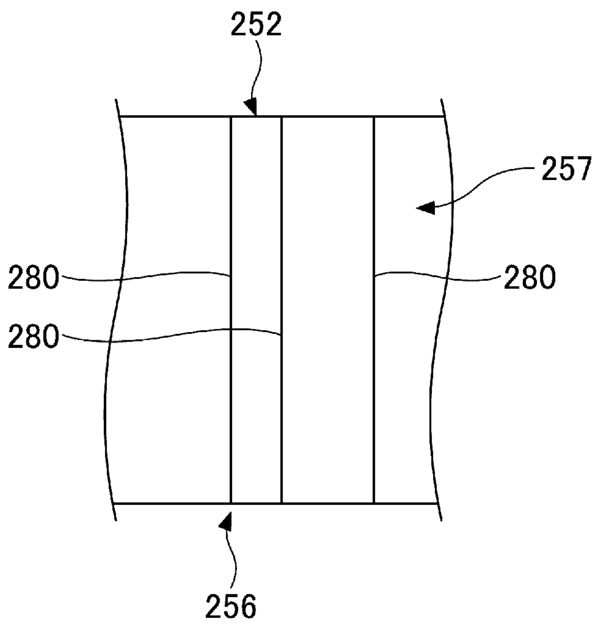


FIG.13

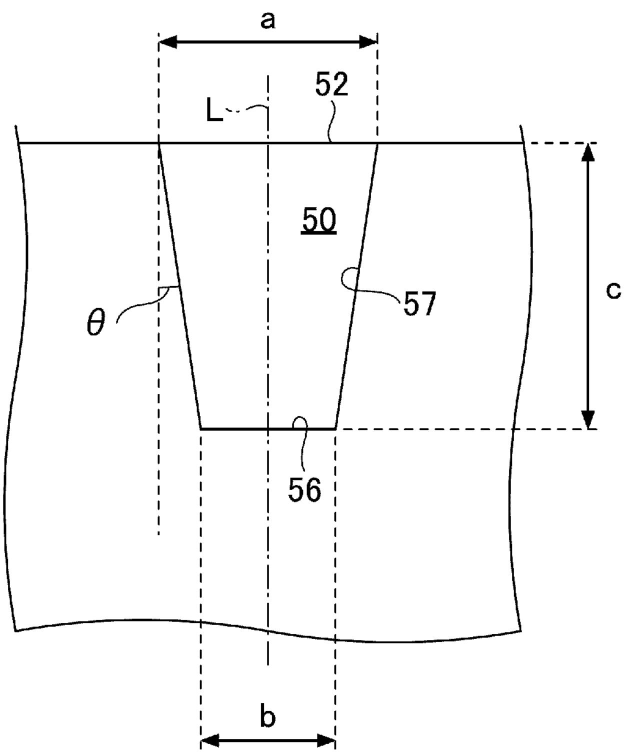

FIG.14

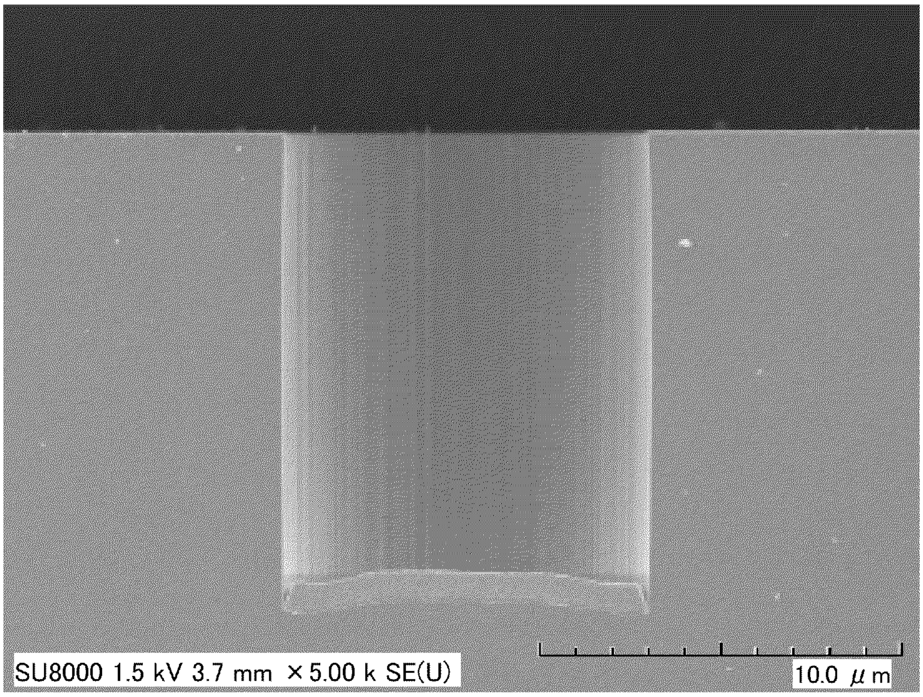
SU8000 1.5 kV 3.7 mm ×5.00 k SE(U)
10.0 μm

FIG.15

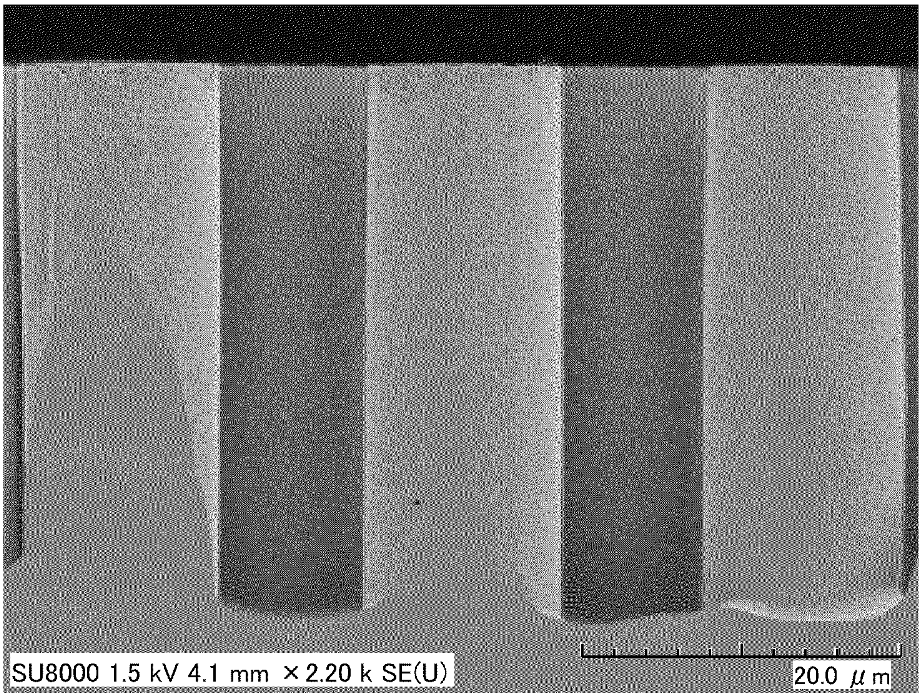
SU8000 1.5 kV 4.1 mm ×2.20 k SE(U)
20.0 μm

FIG.16

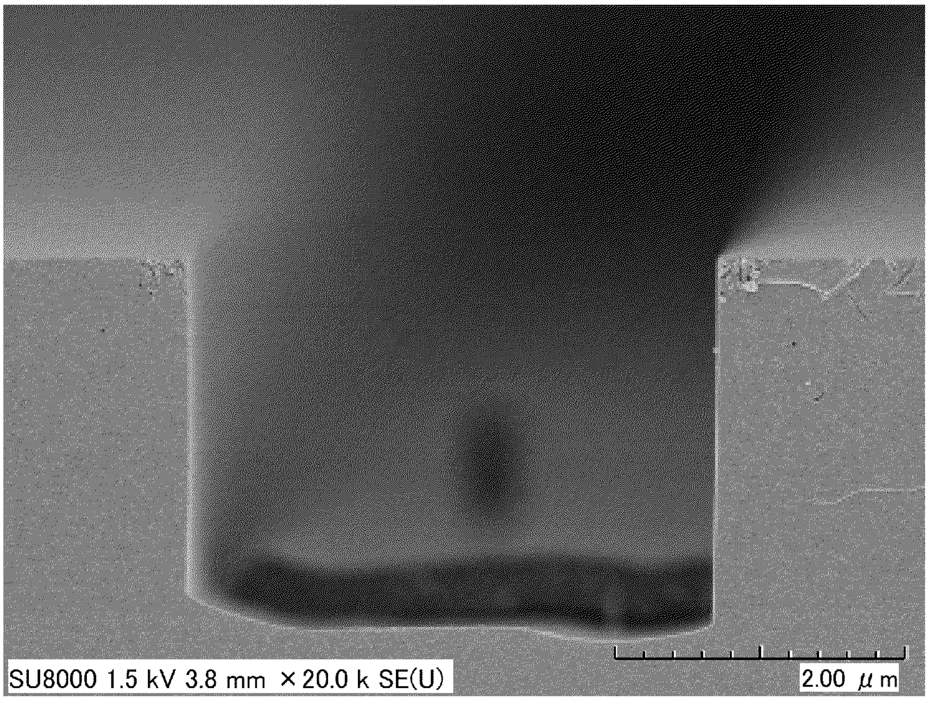
SU8000 1.5 kV 3.8 mm ×20.0 k SE(U)
2.00 μm

FIG.17

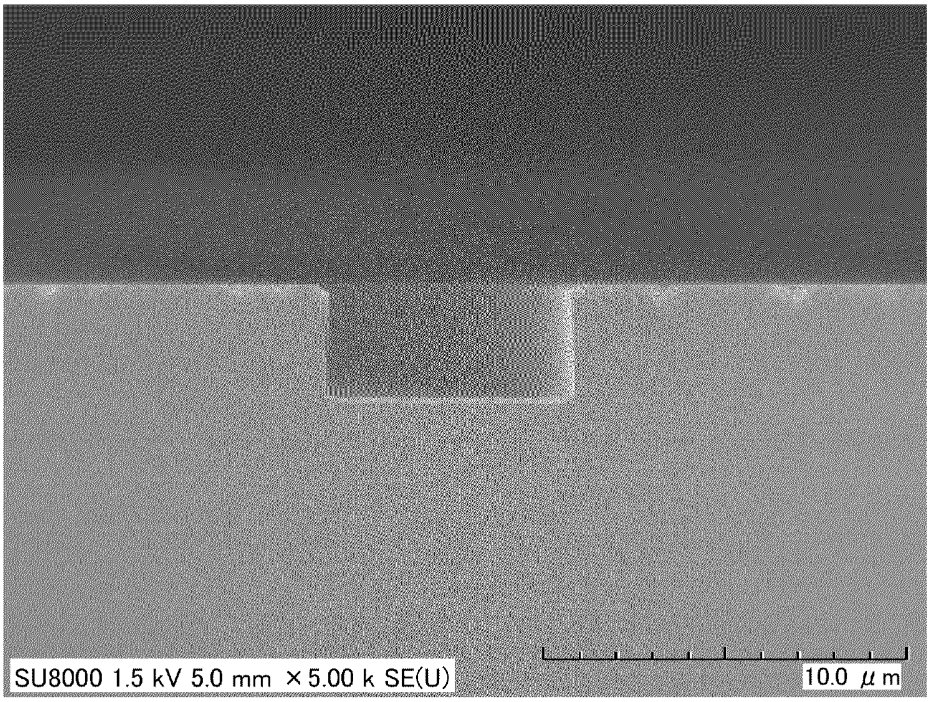
SU8000 1.5 kV 5.0 mm ×5.00 k SE(U)
10.0 μm

FIG.18

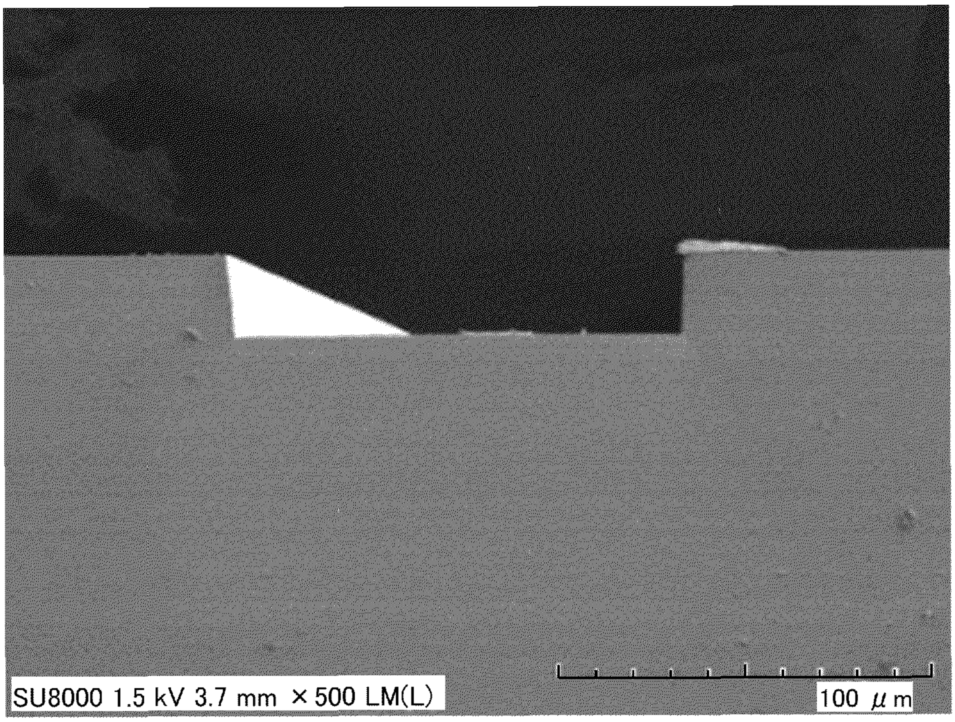

FIG.19

OPENING

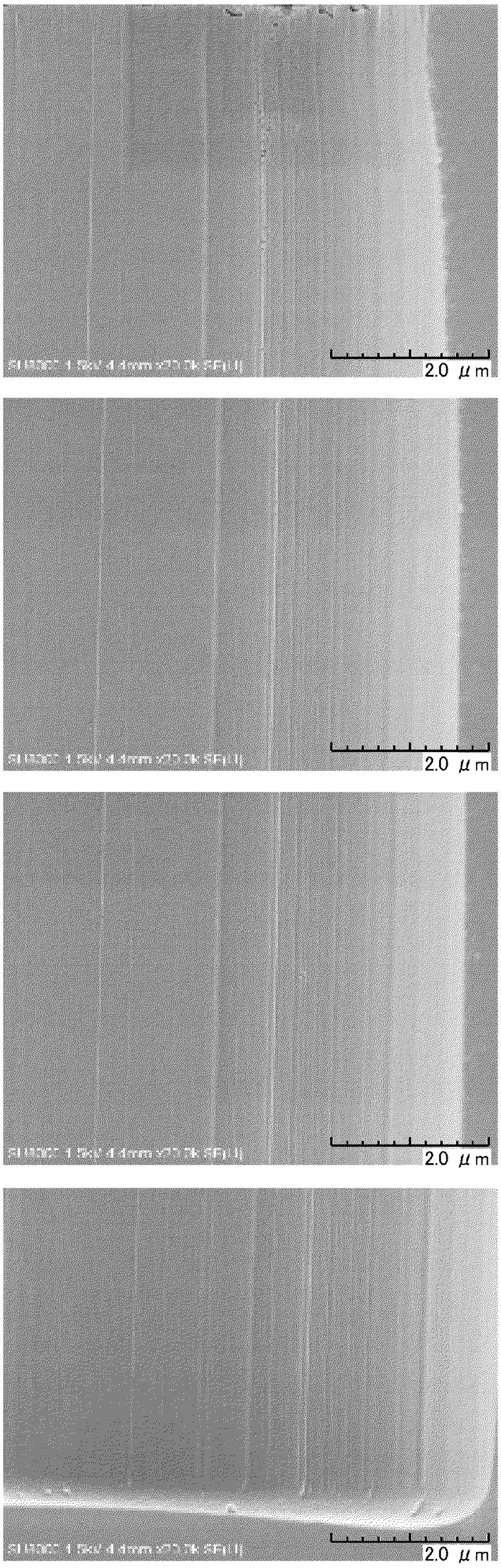


BOTTOM

## INTERNATIONAL SEARCH REPORT

International application No.
**PCT/JP2022/040993**

**A. CLASSIFICATION OF SUBJECT MATTER**

***H01L 21/302***(2006.01)i
FI: H01L21/302 201A

According to International Patent Classification (IPC) or to both national classification and IPC

**B. FIELDS SEARCHED**

Minimum documentation searched (classification system followed by classification symbols)

H01L21/302

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| Y | SHIBATA, Tadashi et al. A deffect-free field isolation technology for high density n-channel MOS LSI's. 1978 International Electron Devices Meeting Technical Digest. 1978, pp. 177-180<br>p. 177, right column, liens 6-35, fig. 2 | 1-25 |
| Y | WESTON, D. F. et al. HF vapor phase etching (HF/VPE): Production viability for semiconductor manufacturing and reaction model. Journal of Vacuum Science and Technology. 1980, vol. 17, no. 1, pp. 466-469<br>column "Abstract", p. 466, left column to p. 469, left column, fig. 2, 4, table 1 | 1-25 |
| A | JP 2021-525459 A (BEIJING NAURA MICROELECTRONICS EQUIPMENT CO., LTD.) 24 September 2021 (2021-09-24)<br>entire text, all drawings | 1-25 |

☐ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **12 January 2023** | **24 January 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/040993**

| Patent document cited in search report | Publication date (day/month/year) | Patent family member(s) | Publication date (day/month/year) |
|---|---|---|---|
| JP 2021-525459 A | 24 September 2021 | WO 2019/228027 A1<br>entire text, all drawings<br>CN 108847391 A<br>TW 202004891 A<br>KR 10-2020-0139758 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021210305 A


### Non-patent literature cited in the description


- **XIAO LI ; KING YUK CHAN ; RODICA RAMER.** Fabrication of Through via Holes in Ultra-Thin Fused Silica Wafers for Microwave and Millimeter-Wave Applications. *Micromachines,* 2018, vol. 9, 138